# EUROPÄISCHE PATENTSCHRIFT

(11) **EP 4 229 346 B1**
(45) Veröffentlichungstag und Bekanntmachung des Hinweises auf die Patenterteilung: **31.07.2024**
(21) Anmeldenummer: 21830955.7
(22) Anmeldetag: 01.12.2021
(51) Int. Cl.: F28D 15/02

(54) **HEATPIPEKÜHLKÖRPER FÜR EINEN PULSIERENDEN BETRIEB UND HERSTELLVERFAHREN FÜR EINEN DERARTIGEN HEATPIPEKÜHLKÖRPER**
HEAT PIPE COOLER FOR PULSATING OPERATION AND METHOD FOR PRODUCING SUCH A HEAT PIPE COOLER
DISSIPATEUR THERMIQUE DE CALODUC POUR UN FONCTIONNEMENT DE PULSÉ ET PROCÉDÉ DE FABRICATION POUR UN TEL DISSIPATEUR THERMIQUE DE CALODUC

(30) Priorität: 17.12.2020 EP 20215036
(43) Veröffentlichungstag der Anmeldung: 23.08.2023
(60) Teilanmeldung: 24156514.2
(73) Patentinhaber: Siemens Aktiengesellschaft, 80333 München (DE)
(72) Erfinder: MÜLLER, Volker, 90459 Nürnberg (DE); NEUGEBAUER, Stephan, 91058 Erlangen (DE); SCHWARZ, Florian, 90766 Fürth (DE)
(74) Vertreter: Siemens Patent Attorneys
(86) Internationale Anmeldenummer: PCT/EP2021/083761
(87) Internationale Veröffentlichungsnummer: WO 2022/128474

(56) Entgegenhaltungen:
- EP-A1- 3 723 123
- CN-C- 1 320 643
- JP-A- H06 201 281
- RU-C1- 2 348 963
- US-A- 5 806 583
- US-A1- 2016 054 074

## Beschreibung

Die Erfindung betrifft einen Heatpipekühlkörper, wobei der Heatpipekühlkörper für einen Betrieb als pulsierende Heatpipe eingerichtet ist, wobei der Heatpipekühlkörper einen Körper aufweist. Ferner betrifft die Erfindung ein Verfahren zur Herstellung eines derartigen Kühlkörpers. Die Erfindung betrifft weiter eine Leistungshalbleitereinheit mit einem derartigen Heatpipekühlkörper und mindestens einem Leistungshalbleitermodul sowie einen Stromrichter mit einem derartigen Heatpipekühlkörper oder einer derartigen Leistungshalbleitereinheit.

Heatpipekühlkörper haben sich bereits seit Jahren für eine wirkungsvolle Kühlung auf dem Markt durchgesetzt. Dabei verdampft durch den Wärmeeintrag einer Wärmequelle in einem geschlossenen Rohr des Heatpipekühlkörpers eine Flüssigkeit. Durch das Vakuum im geschlossenen Rohr kondensiert die Flüssigkeit an einer anderen Stelle des Rohres, von der die Wärme dann beispielsweise an die Umgebungsluft abgegeben werden kann. Zum Zurückfließen der Flüssigkeit im Rohr wird der Kapillareffekt genutzt. Dafür wird die Innenseite des Rohres mit einer porösen Struktur versehen. Heatpipekühlkörper die den Oberbegriff des Anspruchs 1 zeigen sind aus den Dokumenten US 5 806 583 A, CN 1 320 643 C, US 2016/054074 A1 sowie JP H06 201281 A bekannt.

Bei dem Betrieb der pulsierenden Heatpipe (PHP), auch als oszillierende Heatpipe bezeichnet, wird die poröse Struktur nicht benötigt. Die Innenseite des Rohres kann auch glatt ausgeführt sein. Auch bei der pulsierenden Heatpipe erfolgt der die Wärmeübertragung über eine Flüssigkeit, wobei Teile der Flüssigkeit gasförmig im Rohr vorhanden ist. Aufgrund des Wärmeeintrags beginnt die Flüssigkeit im Rohr sich hin- und her zu bewegen. Dieses Pulsieren gibt der Heatpipe seinen Namen.

Das Rückfließen der Flüssigkeit zur Wärmequelle, an der durch das Verdampfen die Kühlwirkung entfaltet wird, erfolgt durch wechselnde Siede- und Kondensationsprozesse, unterstützt durch die Geometrie des Rohres, das den Kanal bildet. Die Abmessungen, insbesondere der Querschnitt des Kanals wird so gewählt, dass der Effekt der Schwerkraft gegenüber der Oberflächenspannung geringer ist und so die Flüssigkeit sich auch entgegen der Schwerkraft im Kanal ausbreiten kann. Mit anderen Worten ist die Geometrie derart ausgestaltet, dass der Effekt der Oberflächenspannung gegenüber der Schwerkraft dominiert. Somit ist für die pulsierende Heatpipe keine poröse Struktur mehr erforderlich, sondern die Kapillarwirkung kommt aufgrund der Geometrie zur Wirkung.

Der Erfindung liegt die Aufgabe zugrunde, einen Heatpipekühlkörper insbesondere im Hinblick auf Leistungsfähigkeit der Kühlung und Herstellbarkeit zu verbessern.

Diese Aufgabe wird durch einen Heatpipekühlkörper gemäß Anspruch 1 gelöst.

Ferner wird diese Aufgabe durch eine Leistungshalbleitereinheit mit einem derartigen Heatpipekühlkörper und mindestens einem Leistungshalbleitermodul gelöst, wobei das Leistungshalbleitermodul thermisch leitend mit dem Heatpipekühlkörper derart verbunden ist, dass die durch Verlustleistung des Leistungshalbleitermoduls entstehende Wärme mittels des Heatpipekühlkörpers an das Kühlmedium, insbesondere an das gasförmige Kühlmedium oder an die Umgebungsluft, abführbar ist. Die Aufgabe wird weiter durch einen Stromrichter mit einem derartigen Heatpipekühlkörper oder einer derartigen Leistungshalbleitereinheit gelöst. Die Aufgabe wird ferner durch ein Verfahren zur Herstellung eines derartigen Heatpipekühlkörpers gelöst, wobei in einem ersten Schritt der Körper oder Blockteile in Blockform hergestellt werden, wobei der Körper einen Kanal aufweist oder die Blockteile derart verbunden werden, dass im Innern der verbundenen Blockteile ein Kanal entsteht, wobei der Kanal sich in einer Ebene erstreckt, wobei in einem zweiten Schritt der Körper oder die Blockteile derart umgeformt oder gebogen werden, dass sich der erste Körperabschnitt mit einer gekrümmten, wechselseitig gekrümmten, insbesondere einer quer zur Verlaufsrichtung oder einer Vorzugsrichtung der Verlaufsrichtung des Kanals gekrümmten, mäanderförmigen oder U-förmigen Struktur ergibt.

Weitere vorteilhafte Ausgestaltungen der Erfindung sind in den abhängigen Ansprüchen angegeben.

Der Erfindung liegt unter anderem die Erkenntnis zugrunde, dass die thermische Effizienz des ersten Körperabschnitts in einem Heatpipekühlkörper sehr stark von der Wärmeleitfähigkeit des verwendeten Materials abhängt. Die Integration einer pulsierenden Heatpipe in den ersten Körperabschnitt kann die Wärmeleitfähigkeit um ein Vielfaches erhöhen und damit deutlich die thermische Effizienz verbessern. Damit kann insbesondere bei besserer Kühlleistung auf teurere Materialien wie Kupfer verzichtet werden. Generell sind aber alle strukturell hinreichend stabilen (und umformbaren) Materialien denkbar, so z.B. auch elektrisch isolierende oder extrem korrosionsresistente oder verschleißunempfindliche Materialien. Vorzugsweise ist der Körper ein Aluminiumkörper oder ein Körper aus einem Kunststoff. Diese sind am Markt verfügbar, kostengünstig herstellbar und weisen eine hinreichend gute Wärmeleitfähigkeit auf.

Eine Herausforderung bei der Integration der pulsierenden Heatpipe in den ersten Körperabschnitt ist die kosteneffiziente Herstellung, um eine Anwendung in typischen Industrieanwendungen zu marktüblichen Preisen zu ermöglichen.

Der vorgeschlagene Ansatz ist, die einzelnen Körper mit dem ersten Körperabschnitt des Heatpipekühlkörpers aus nur einem Bauteil zu erzeugen. Dieses ist mit einer oder mehreren PHP-Strukturen versehen und abwechselnd beispielsweise mit größerem Biegewinkeln (um 180°) gebogenen, so dass eine Art Schlangenform, Mäanderform oder U-Form entsteht, wobei hier die sich einstellenden Abstände zwischen den Biegungen beliebig variiert werden können und dabei auch die Größe des Heatpipekühlkörpers variiert werden kann. Alternativ kann es in vorgegebenen Abständen beispielsweise mit größerem Biegewinkel abwechselnd zweimal um 90° nach rechts und zweimal 90° nach links gebogen werden, um ein ähnliches Ergebnis zu erzielen, bei dem die Kontaktfläche mit der Wärmequelle besser variiert werden kann.

Idealerweise wird der größte Teil, der Körper, des Heatpipekühlkörpers im ebenen Zustand (z.B. Präge-, Fräs- oder Rollprozess) oder bereits bei einem Extrusionsprozess erzeugt. Ein nachträgliches Umformen des Körpers in seinem ersten Körperabschnitt führt dann zur endgültigen Kühlkörpergeometrie.

Zum Abschließen/Verbinden der PHP-Struktur können dann je nach Prozess noch Endstücke erzeugt werden. Dies kann beispielsweise mittels Bandverschweißen geschehen.

Die Verbindungen, die innerhalb der Endstücke oder innerhalb eines aus mehreren blockförmigen Stücken verlaufen, dienen beispielsweise der Reihenschaltung mehrerer Kanäle oder deren Parallelschaltung zur gleichzeitigen Befüllung. Mit anderen Worten können durch die Endstücke zwei oder mehr Kanäle, insbesondere zwei oder mehr benachbarte Kanäle, miteinander verbunden werden.

Die Endstücke können beispielsweise geprägt, gefräst, gebohrt, 3D-gedruckt, gespritzt und gegossen werden, insbesondere auch mit verlorener Form. Es sind sowohl additiv hinzugefügte Endstücke möglich wie auch die Integration des Endstücks in den Körper. Das Material kann bei additiv hinzugefügten Endstücken auch ein anderes als Aluminium sein. 3D-gedruckte oder mit verlorener Form gegossene Endstücke weisen hier ein Potenzial bei der hydraulischen Optimierung zur Performancesteigerung der pulsierenden Heatpipe auf.

Möglich ist auch, die Enden, insbesondere beide Enden, des Körpers mit nur einem Endstück zu verschließen und insbesondere gleichzeitig zu verbinden, um eine umlaufende PHP-Geometrie zu erreichen. Dies kann sich je nach Geometrie anbieten, um einen stabileren Betrieb des Heatpipekühlkörpers und/oder ein leichteres Anlaufen der pulsierenden Heatpipe zu ermöglichen. Ein besonderer Vorteil dieser Anordnung besteht darin, dass nur maximal zwei Abschlussteile, insbesondere genau ein Abschlussteil, für den Körper erforderlich sind, um die Kanalabschnitte zu verbinden. Alternativ kann der Körper auch abschlussteilfrei ausgeführt sein. Da der Kanal der Kühlung dient wird er im folgenden auch als Kühlkanal bezeichnet.

Somit lässt sich eine hohe Leistungsfähigkeit und eine einfache Herstellbarkeit des Heatpipekühlkörpers dadurch erreichen, dass der Körper zuerst in einer Blockform mit innenliegenden mäanderförmigen Kühlkanälen erzeugt wird. Unter einer Blockform ist ein Polygonkörper zu verstehen, der mäanderförmig umgeformt oder gebogen werden kann. Ein Beispiel für eine solche Blockform ist ein Quader. Dabei muss eine solche Blockform oder ein solcher Quader nicht notwendigerweise ebene Flächen als Ränder aufweisen. Auch müssen diese nicht paarweise parallel zueinander sein. Dies wird im folgenden mit den Worten beschrieben, dass der Block im Wesentlichen einem Quader entspricht oder im Wesentlichen in Quaderform ausgeführt ist, da der Körper nicht notwendigerweise ebene Flächen als Ränder oder paarweise parallele Oberflächen aufweisen muss. Um beispielsweise einen besseren Wärmeübergang an das Kühlmedium zu erzeugen, kann die Oberfläche gegenüber einer ebenen Form erhöht werden. Dies kann beispielsweise durch eine Wellenform, insbesondere an Teilen des Körpers, die für die Bildung des ersten Körperabschnitts vorgesehen sind, geschehen. Darüber hinaus ist auch eine Aufrauhung der Oberfläche durch herausstehende oder hineinrechende Elemente möglich. In einem nächsten Schritt wird dieser Körper derart umgeformt oder gebogen, dass dieser in dem ersten Körperabschnitt eine mäanderförmige oder U-Förmige Ausgestaltung erhält. Dabei kann der Körper beispielsweise in 90° oder 180° Bögen gebogen werden. Darüber hinaus ist es auch beispielsweise möglich, den Alukörper in 270° Bögen zu biegen, wobei sich dann vorteilhafterweise diese Bögen mit unterschiedlicher Richtung direkt aneinander anschließen. Dieser erster Körperabschnitt mit mäanderförmiger oder U-förmiger Ausgestaltung kann von einem Kühlmedium, wie beispielsweise Luft durchströmt werden. Dadurch kann eine leistungsfähige Kühlung erzielt werden.

Bei der Leistungshalbleitereinheit können der Heatpipekühlkörper und das Leistungshalbleitermodul eine Einheit oder Teil einer Einheit bilden. Beispielsweise kann die Bodenplatte des Leistungshalbleitermoduls durch den Heatpipekühlkörper oder einem Teil des Heatpipekühlkörpers gebildet werden.

Es hat sich als besonders vorteilhaft für die Wärmeübertragung beim Heatpipekühlkörper erwiesen, wenn die Vorzugsströmungsrichtung des Kühlmediums lateral zu den Bestückungsflächen für die Wärmequellen erfolgt.

Bei einer vorteilhaften Ausgestaltung der Erfindung weist ein senkrecht zum Kanal ausgerichteter Querschnitt des Körpers im ersten Körperabschnitt über eine ununterbrochene Länge von mindestens 80% der Gesamtlänge des Körpers entlang des Kanals die gleichen Abmessungen auf. Mit anderen Worten ist in einer vorteilhaften Ausgestaltung der Erfindung der Körper über mindestens 80% der Abmessung in einer ersten Richtung über die Länge in erster Richtung ununterbrochen fügestellenfrei ausgebildet, wobei die erste Richtung der Vorzugsrichtung des Verlaufs des Kanals entspricht. Ein besonderer Vorteil des vorgeschlagenen Ausführungsbeispiels des Heatpipekühlkörpers liegt darin, dass keine oder, wenn überhaupt, nur wenige Abschlussteile benötigt werden. Dabei kann alternativ zum gleichbleibenden Querschnitt der Querschnitt des Kanals die gleichen Abmessungen aufweisen. Dabei sind in dem ersten Körperabschnitt im Wesentlichen, bis beispielsweise mit Ausnahme von einem oder mehreren Abschlussteilen kein Fügestellen vorhanden, so dass dieser teilweise oder sogar vollständig fügestellenfrei ausgebildet ist. Durch den Verzicht auf Fügestellen kann die Umformung besonders einfach durchgeführt werden. Die Bruchgefahr, die ansonsten an Fügestellen erhöht ist, ist durch diese Ausgestaltung nicht oder nur reduziert vorhanden. Der größte Teil des ersten Körperabschnitts ist frei von Unterbrechungen mit Abschlussteilen. Das äußert sich darin, dass der erste Körperabschnitt über mindestens 80% seiner Länge entlang des Kanals den gleichen Querschnitt aufweist. Dabei bleibt in vorteilhafter Weise auch der Querschnitt des Kanals über diese Länge im Wesentlichen konstant. Änderungen in der Kanalstruktur ergeben sich nur durch das Biegen im Herstellungsprozess.

Bei einer weiteren vorteilhaften Ausgestaltung der Erfindung weist der Heatpipekühlkörper am ersten Körperabschnitt Kühlrippen auf. Durch die Anordnung von Kühlrippen an die Oberfläche des Körpers, insbesondere im Bereich des ersten Körperabschnitts, kann die Wärmeabgabe vom Heatpipekühlkörper an das Kühlmedium, das an dem ersten Körperabschnitt entlangströmt, noch besser und wirkungsvoller abgegeben werden. Insbesondere bei kleinen Temperaturunterschieden zwischen dem Heatpipekühlkörper und dem Kühlmedium wie beispielsweise Luft kann der Wärmeübergang deutlich verbessert werden.

Erfindungsgemäß weist der Heatpipekühlkörper mindestens zwei Körper auf. Es hat sich als vorteilhaft erwiesen, den Heatpipekühlkörper modular mit einer Vielzahl von Körpern, also mindestens zwei Körpern aufzubauen. Dabei können die Körper gleich ausgebildet sein oder sich unterscheiden. Dadurch wird die Kühlung redundant gestaltet. Selbst beim Ausfall der Kühlwirkung eines Körpers, beispielsweise durch eine Undichtigkeit im Kanal, wird durch die übrigen Körper eine hinreichende Kühlung weiterhin sichergestellt. Ebenso ist es möglich, Heatpipekühlkörper mit unterschiedlicher Leistungsfähigkeit herzustellen, indem eine unterschiedliche Anzahl gleicher Körper zur Bildung des Heatpipekühlkörpers zur Anwendung kommen. Mit anderen Worten weist der Heatpipekühlkörper eine Vielzahl gleicher Körper auf. Dabei ergibt sich die Anzahl der Körper in Abhängigkeit von der Leistungsfähigkeit des Heatpipekühlkörpers. Damit lassen sich eine Vielzahl von Heatpipekühlkörpern mit unterschiedlicher Leistungsfähigkeit kostengünstig herstellen.

Bei einer weiteren vorteilhaften Ausgestaltung der Erfindung sind die Körper aus Sicht des durchströmenden Kühlmediums hintereinander angeordnet. Bei dieser Anordnung können die Körper auf einfache Weise aneinander befestigt werden, da sie aus gleichem Material (Aluminium) sind und damit auch der gleichen Ausdehnung bei Erwärmung unterliegen. Ermüdungserscheinungen aufgrund unterschiedlicher Ausdehnung wird damit zuverlässig vermieden und der Heatpipekühlkörper erzielt eine hohe Lebensdauer.

Bei einer weiteren vorteilhaften Ausgestaltung der Erfindung weist der Heatpipekühlkörper eine Bodenplatte auf, wobei die Bodenplatte mit dem Körper wärmeleitend verbunden ist, wobei die Bodenplatte für die Verbindung mit einer Wärmequelle vorgesehen ist. Die Bodenplatte kann dabei derart ausgelegt werden, dass die Wärmequelle, beispielsweise ein Halbleiter, bei höheren Leistungen und damit einhergehenden Verlustleistungen auch als Leistungshalbleiter bezeichnet, sicher an der Bodenplatte des Heatpipekühlkörpers befestigt werden kann. Gleichzeitig erfolgt durch die Bodenplatte eine Wärmespreizung, so dass die Wärme gleichmäßig an den Körper übertragen wird. Dabei kann die Bodenplatte Ausnehmungen aufweisen, die einen Teil des mäanderförmigen oder U-förmigen Körperabschnitts des ersten Bereichs des Körpers aufnehmen können. Durch die Vergrößerung der Kontaktfläche zwischen Körper und Bodenplatte wird der Wärmeübertrag zwischen Bodenplatte und Körper verbessert und die Leistungsfähigkeit des Heatpipekühlkörpers nimmt zu. Die Bodenplatte und der Körper können beispielsweise mittels Lötens, Schweißen, Kleben, Klemmen, Verpressen oder einem anderen Verfahren dauerhaft miteinander verbunden werden.

Bei einer weiteren vorteilhaften Ausgestaltung der Erfindung ist die Wärmequelle am Rand der Bodenplatte angeordnet. Diese Anordnung ist besonders vorteilhaft, da damit ein besonders guter Wärmeübergang von der Wärmequelle über die Bodenplatte zum Kühlkanal erreichbar ist. Damit ist der Heatpipekühlkörper im Hinblick auf die Wärmeübertragung an die Umgebung besonders leistungsfähig.

Bei einer weiteren vorteilhaften Ausgestaltung der Erfindung ist der erste Körperabschnitt U-förmig ausgebildet, wobei der erste Körperabschnitt mit einem Abschlussteil derart, insbesondere mit sich selbst, verbunden ist, dass sich ein ringförmiger Körper ergibt. Durch diese Ausgestaltung kann eine Vielzahl von unabhängigen Kühlkanälen in einem Heatpipekühlkörper erzeugt werden.

Die Vielzahl an Kühlkanälen kann dabei beispielsweise durch eine Reihen- oder Parallelschaltung mehrerer oder aller Kühlkanäle ausgeführt werden.

Damit weist ein derartig aufgebauter Heatpipekühlkörper eine hohe Redundanz auf. Die ringförmigen Körper des Heatpipekühlkörpers können darüber hinaus auf einfache Weise von Kühlluft durchströmt werden. Darüber hinaus kann der erste Teil des Körpers auf einfache Weise durch nur einen Biegevorgang erzeugt werden.

Unter der Ringform ist eine geschlossene Form zu verstehen. Darunter fallen beispielsweise eine Kreisform, eine Ovalform oder auch zwei parallele Anschnitte, die an ihren Enden durch halbkreisförmige Abschnitte geschlossen werden.

Bei einer weiteren vorteilhaften Ausgestaltung der Erfindung weist der Körper einen zweiten Körperabschnitt auf, der eine ebene Oberfläche aufweist, wobei die Oberfläche für die Verbindung mit einer Wärmequelle vorgesehen ist. Bei dieser Ausgestaltung ist die Wärmequelle besonders nahe an den Kanal des Körpers angeordnet. Durch die Nähe zu diesem Kanal kann die hocheffiziente Kühlung der Heatpipe besonders gut genutzt werden. Insbesondere ist es vorteilhaft, die Wärmequelle in der Umgebung mehrerer Kühlkanäle oder mehrerer Teilsektionen des Kühlkanals oder der Kühlkanale anzuordnen. Dabei hat es sich als vorteilhaft erwiesen, die Wärmequelle vorzugsweise flächig an einer Ebene anzuordnen, die parallel zu der Fläche ist, in der die Kühlkanäle verlaufen. Hohe Wärmemengen können ohne nennenswerten Zeitverzug von der Wärmequelle wegtransportiert werden. Zudem kann der Heatpipekühlkörper aus nur wenigen Teilen aufgebaut werden. Im einfachsten Fall besteht der Heatpipekühlkörper nur aus dem Körper mit einem ersten Bereich für das Durchströmen der Kühlluft und einem zweiten Bereich für die Anordnung der Wärmequelle. Damit ist auf einfache Weise ein leistungsfähiger und leichter Kühlkörper auf kostengünstige Weise herstellbar.

Weiterhin sind mit ringförmig geschlossenen ersten Körperabschnitte auch Strömungen innerhalb des Kanals mit Vorzugsrichtung möglich. Hier bietet sich unter anderem auch die Verwendung eines muffenartig ausgebildeten Verbindungsstückes an. Diese Muffe charakterisiert sich durch einen umlaufenden Kragen, der die genaue Positionierung der zwei offenen Enden des U-förmig ausgeformten Bereichs des Körpers sowohl genau positioniert als auch mechanisch vor Verschieben sichert. Die Verbindungsmuffe beinhaltet vorzugsweise den Befüll- und Verschlussmechanismus.

Erfindungsgemäß wird der Körper aus mindestens zwei Blockteilen zusammengesetzt. Das Fertigen des Kanals lässt sich auf einfache Weise durchführen, wenn der Körper sich aus zwei Blockteilen zusammensetzt. Dann können Teile des Kanals jeweils an einer Grenzfläche der Blockteile angeordnet werden. Anschließend kann beispielsweise durch Löten, Schweißen, Kleben, Klemmen, Verpressen oder einem anderen Verfahren der Körper aus den Blockteilen gebildet werden. So lässt sich der Kühlkanal auf besonders einfache Weise in den Körper einbringen.

Dabei können bei der Herstellung des Körpers aus zwei Blockteilen zuerst die beiden Blockteile zum Körper verbunden werden oder alternativ können erst die Blockteile umgeformt oder gebogen werden und anschließend zu einem Körper verbunden werden.

Bei einer weiteren vorteilhaften Ausgestaltung der Erfindung wird der Körper in Blockform mittels eines Stranggussverfahrens hergestellt. Allgemein formuliert wird bei dieser weiteren vorteilhaften Ausgestaltung der Erfindung der Körper oder die Blockteile in einer Blockform mittels eines Extrusionsverfahrens, insbesondere eines Strangpressverfahrens oder eines Stranggussverfahrens, oder eines Spritzgussverfahrens hergestellt. Das Stranggussverfahren bzw. alternativ das Extrusionsverfahren hat sich als kostengünstiges Herstellverfahren für Körper erwiesen. Ein Ansatz ist hierbei die zumindest die teilweise Herstellung des Körpers und der dazugehörigen inneren Struktur der pulsierenden Heatpipe mittels Strangpressen. Wenn allerdings nur einzelne U-förmig, ausgebildete erste Körperabschnitte des Körpers vorgesehen sind, müssen diese dann wiederum alle an beiden Enden Verbindungsstrukturen aufweisen, um die interne Kühlstruktur der oszillierenden Heatpipe abzuschließen, was wiederum zu erhöhten Kosten führen kann. Hierbei ist Aluminium am besten geeignet, welches bei Kühlkörpern derzeit in der Regel auch das beste Kosten-Nutzen-Verhältnis aufweist. Bei einigen Anwendungen ist hier aber auch die Anwendung von Kunststoff alternativ denkbar. Insbesondere, wenn die Kühlstruktur Feuchtigkeit oder korrosiven Medien ausgesetzt ist oder eine elektrische Isolation notwendig ist, ist die Verwendung von Kunststoff vorteilhaft.

Bei einer weiteren vorteilhaften Ausgestaltung der Erfindung wird der Körper gefräst, gedrückt oder gepresst, insbesondere wird der Kanal in die zwei Blockteile gefräst, gedrückt oder gepresst. Auch das Fräsen ist eine einfache Fertigungsmethode. Gerade für die Fertigung des Körpers aus zwei Blockteile bietet sich das Fräsen zum Einbringen des Kanals in die beiden Blockteile an. Die einzelnen Blockteile können in einem ersten Schritt als identischer Block hergestellt werden. In einem zweiten Schritt wird die Struktur des Kanals in die Blockteile gefräst, gedrückt oder gepresst. Dabei kann das Fräsen der Kanalanteile und damit die Ausbildung des Kanals beispielsweise abhängig von der Ausbildung der Wärmequelle unterschiedlich gestaltet werden.

Bei Verwendung verbundener Blockteile können darüber hinaus Kanalverbinder und Befüllöffnungen integriert und dadurch ggf. auf weitere Verbindungs- oder Verschlusselemente verzichtet werden.

Bei einer weiteren vorteilhaften Ausgestaltung der Erfindung weist der Querschnitt des Kanals eine minimale Ausdehnung im Bereich von 0,5mm bis 5mm auf. Dabei hat sich diese Geometrie besonders günstig erwiesen, den Kapillareffekt für eine Vielzahl von Flüssigkeiten zu bewirken. Gleichzeitig ist bei diesen Abmessungen ein hinreichender Fluidstrom bei geringem Druckverlust und damit eine besonders gute Kühlwirkung gewährleistet. Bei der Verwendung von Wasser, ggf. mit einem Zusatz von Frostschutzmitteln, ist eine minimale Ausdehnung im Bereich von 4mm bis 5mm vorteilhaft, da damit bereits ein hinreichender Kapillareffekt erzielbar ist. Andere Flüssigkeiten benötigen zur Realisierung eines hinreichenden Kapillareffekts zumindest teilweise geringere Abmessungen von bis zu 0,5mm.

Es hat sich herausgestellt, dass mit der Geometrie, die diese Abmessungen aufweist, eine besonders hohe Leistungsdichte und Leistungsfähigkeit beim Wärmetransport realisierbar ist. Dies liegt unter anderem daran, dass der Materialtransport nahezu ausschließlich über den im Kanal vorhandenen Dampfdruck erfolgt. Dadurch ist die Wärmeübertragung besonders schnell. Dies ermöglicht es, eine hohe Wärmemenge zu übertragen und damit eine hohe Leistungsdichte eines entsprechenden Kühlkörpers sicherzustellen.

Im Folgenden wird die Erfindung anhand der in den Figuren dargestellten Ausführungsbeispiele näher beschreiben und erläutert. Es zeigen:
- FIG 1 bis FIG 4: Ausführungsbeispiele von Heatpipekühlkörpern und Leistungshalbleitereinheiten,
- FIG 5 bis FIG 7: Ausführungsbeispiel eines Körpers,
- FIG 8 bis FIG 14: Ausführungsbeispiele von Heatpipekühlkörpern und
- FIG 15: einen Stromrichter.

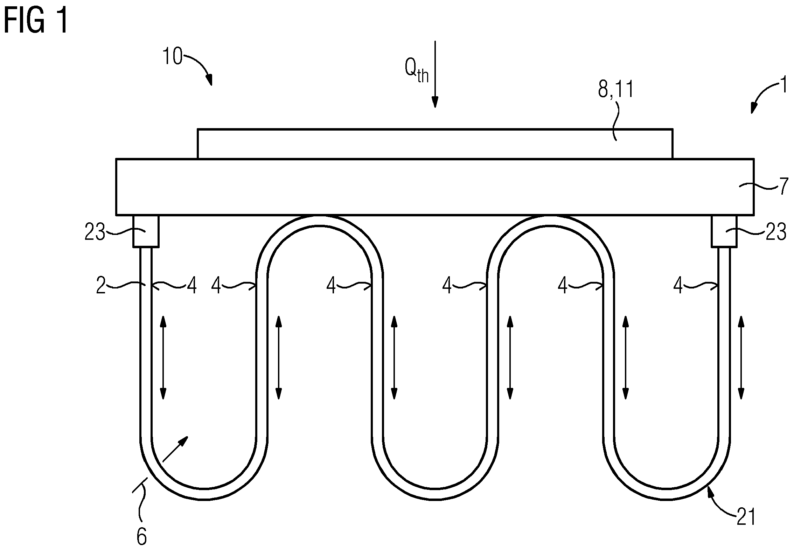

Die FIG 1 zeigt einen Heatpipekühlkörper 1, der einen Körper 2 und eine Bodenplatte 7 aufweist. An der Bodenplatte 7 ist eine Wärmequelle 8 angeordnet, die eine Wärmemenge Qₜₕ in den Heatpipekühlkörper 1 einbringt. Sofern es sich bei der Wärmequelle 8 um eine Leistungshalbleitermodul 11 handelt, wird die Kombination aus Heatpipekühlkörper 1 und Leistungshalbleitermodul 11 als Leistungshalbleitereinheit 10 bezeichnet.

Der Körper 2 weist im Wesentlichen einen mäanderförmig geformten ersten Körperabschnitt 21 auf. Entlang der Oberfläche 4 des ersten Körperabschnitts 21 strömt ein Kühlmedium 6, insbesondere ein gasförmiges Kühlmedium 6 wie beispielsweise Luft. Dieses Kühlmedium 6 ist mit Hilfe eines Pfeils in der vorliegenden FIG dargestellt. Abgeschlossen ist der Körper 2 mit einem Abschlussteil 23. Das Abschlussteil 23 kann vorteilhafterweise auch zum Befüllen eines hier nicht näher dargestellten Kanals 3 genutzt werden.

Das pulsierende Flüssigkeits-Gas Gemisch im Innern des Kanals 3 des Heatpipekühlkörpers 1 ist durch die senkrechten Pfeile mit den beiden Pfeilspitzen angedeutet.

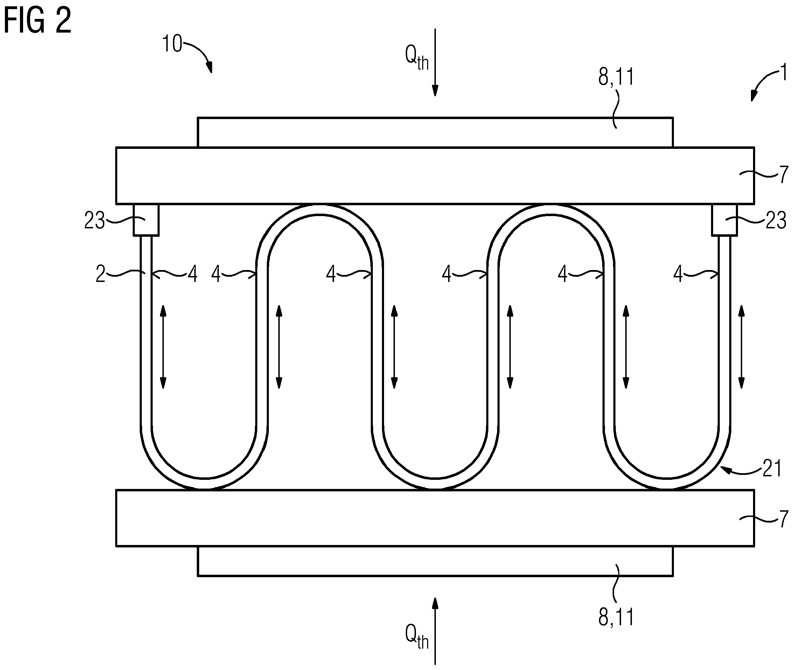

Die FIG 2 zeigt ein weiteres Ausführungsbeispiel eines Heatpipekühlkörpers 1 bzw. einer Leistungshalbleitereinheit 10. Dieses Heatpipekühlkörper 1 weist zwei Bodenplatten 7 auf, an denen jeweils eine Wärmequelle 8 bzw. ein Leistungshalbleitermodul 11 angeordnet ist, die oder das eine Wärmemenge Qₜₕ in den Heatpipekühlkörper 1 einbringt. Zur Vermeidung von Wiederholungen wird auf die Beschreibung zur FIG 1, sowie auf die dort eingeführten Bezugszeichen verwiesen. Auch hier durchströmt das Kühlmedium 6 den Heatpipekühlkörper 1 entlang der Oberfläche 4 des ersten Körperabschnitts 21 des Körpers 2, jedoch ist dies in dieser und den folgenden Figuren nicht weiter mittels des Pfeils und dem dazugehörigen Bezugszeichen dargestellt.

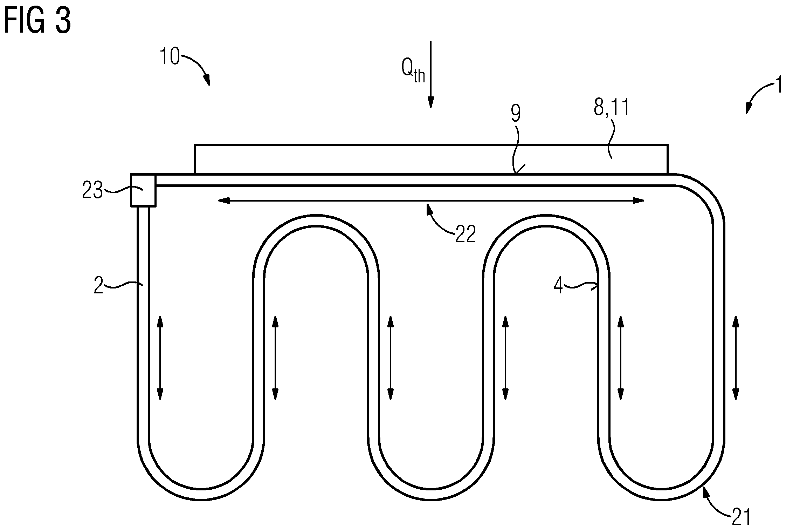

Die FIG 3 zeigt ein weiteres Ausführungsbeispiel eines Heatpipekühlkörpers 1. Dieser Heatpipekühlkörper 1 umfasst keine Bodenplatte 7. Der Heatpipekühlkörper 1 ist somit bodenplattenfrei ausgeführt. Der Körper weist neben dem ersten Körperabschnitt 21 mit mäanderförmiger Ausbildung einen zweiten Körperabschnitt 22 mit einer ebenen Oberfläche 9 auf. An der ebenen Oberfläche 9 des zweiten Körperabschnitts 22 ist die Wärmequell 8 bzw. das Leistungshalbleitermodul 11 angeordnet. Zur Vermeidung von Wiederholungen wird auf die Beschreibung zu FIG 1 und FIG 2, sowie auf die dort eingeführten Bezugszeichen verwiesen.

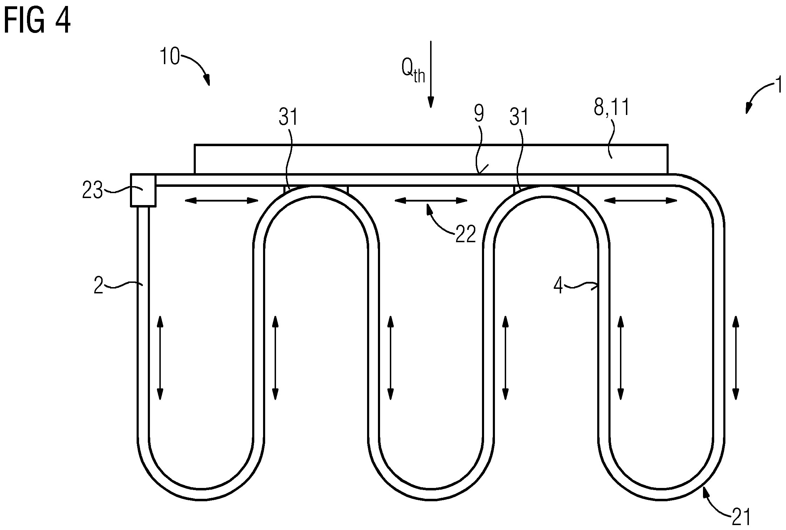

Die FIG 4 zeigt ein weiteres Ausführungsbeispiel eines Heatpipekühlkörpers 1. Dieser Heatpipekühlkörper 1 weist zwischen dem ersten Körperabschnitt 21 und dem zweiten Körperabschnitt 22 Verbindungen 31 zwischen dem ersten Körperabschnitt 21 und dem zweiten Körperabschnitt 22 auf. Mit diesen Verbindungen 31 wird die Wärmemenge Qₜₕ von der Wärmequelle 8, die in den zweiten Körperabschnitt 22 des Körpers 2 eingebracht wird, noch besser an den ersten Körperabschnitt 21 des Körpers 2, bei dem der Übergang an das Kühlmedium bzw. das gasförmige Kühlmedium erfolgt, übertragen. Zur Vermeidung von Wiederholungen wird auf die Beschreibung zu den Figuren 1 bis 3, sowie auf die dort eingeführten Bezugszeichen verwiesen.

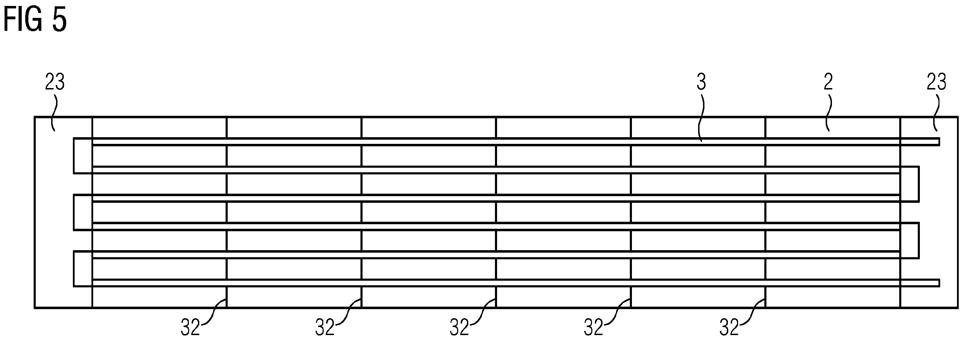

Die FIG 5 zeigt ein Ausführungsbeispiel eines Körpers 2. Dieser Körper 2 hat eine blockförmige Ausgestaltung. Innerhalb des Körpers 2 befindet sich ein Kanal 3. In diesem Kanal 3 liegt ein Fluid in zwei Phasen vor, mit dem die Wirkungsweise der Heatpipe, insbesondere der pulsierende Heatpipe, realisiert wird. Zum Abschluss und ggf. Befüllen des Kanals dienen Abschlussteile 23 des Körpers 2. Im Rahmen der Herstellung des Heatpipekühlkörpers 1 wird der Körper 2 an den Biegestellen 32 in eine Mäanderform oder U-Form umgeformt. Der Bereich des Körpers 2, der mäanderförmig oder U-förmig ausgebildet ist, bildet dann den ersten Körperabschnitt 21, der zum Übergang der Wärme an das Kühlmedium 6 dienst. Zur Vermeidung von Wiederholungen wird auf die Beschreibung zu den Figuren 1 bis 4, sowie auf die dort eingeführten Bezugszeichen verwiesen.

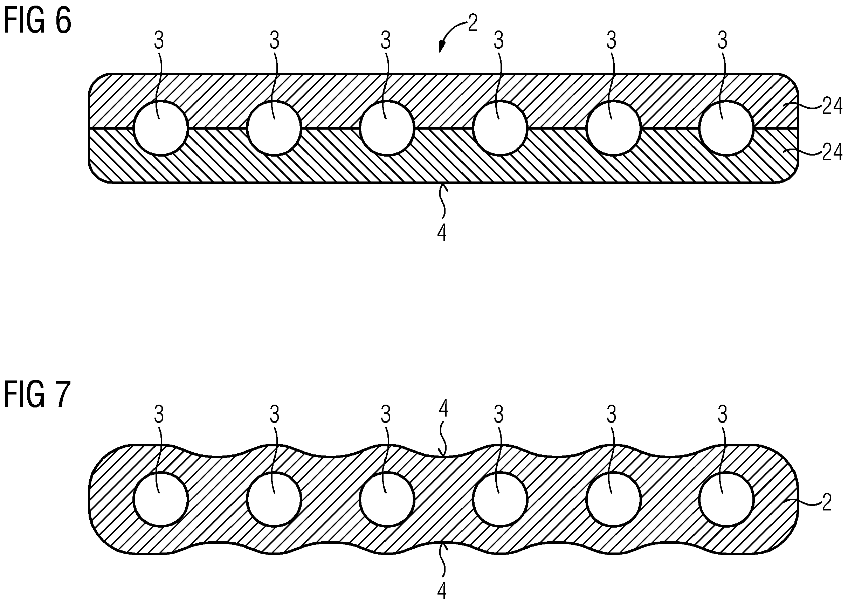

Die FIG 6 zeigt den Körper 2 der FIG 5 in einem anderen Schnitt. Darüber hinaus gliedert sich der Körper 2 in zwei Blockteile 24, die im Rahmen der Herstellung miteinander zu dem Körper 2 verbunden werden. Zur Vermeidung von Wiederholungen wird auf die Beschreibung zu den Figuren 1 bis 5, sowie auf die dort eingeführten Bezugszeichen verwiesen. Der Körper 2 weist im Innern den Kanal 3 auf. Aus der blockförmigen Ausgestaltung des Körpers 2 ergibt sich die im Wesentlichen rechteckförmige Schnittfläche. Um jedoch die Oberfläche 4 des ersten Körperabschnitts 21 zu erhöhen und damit den Wärmeübergang vom Heatpipekühlkörper an das Kühlmedium 6 zu verbessern, kann der Körper an seiner Oberfläche, insbesondere an der Oberfläche 4 des ersten Körperabschnitts 21 eine wellenartige Oberfläche aufweisen, wie sie in FIG 7 gezeigt ist. Alternativ ist auch eine Sägezahnform oder Dreieckform möglich. Auch diese verbessern den Wärmeübergang vom Heatpipekühlkörper 1 an das Kühlmedium 6 und somit die Leistungsfähigkeit des Heatpipekühlkörpers. Zur Vermeidung von Wiederholungen wird auf die Beschreibung zu den Figuren 1 bis 6, sowie auf die dort eingeführten Bezugszeichen verwiesen.

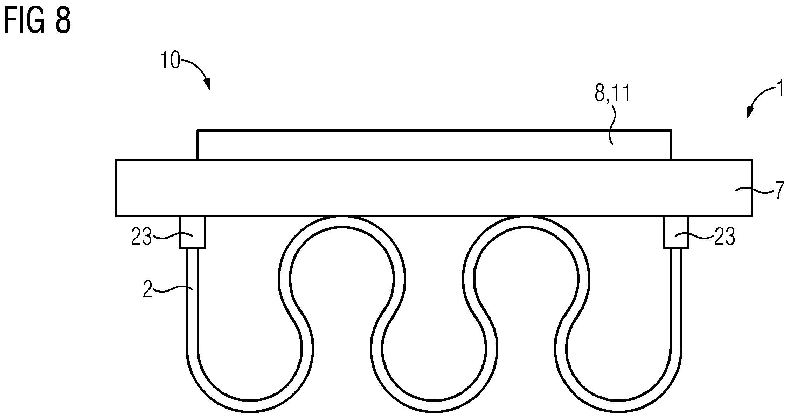

Die FIG 8 zeigt ein weiteres Ausführungsbeispiel eines Heatpipekühlkörpers 1 bzw. einer Leistungshalbleitereinheit 10. Zur Vermeidung von Wiederholungen wird auf die Beschreibung zu den Figuren 1 bis 7, sowie auf die dort eingeführten Bezugszeichen verwiesen. Der mäanderförmige Teil weist dabei Biegungen auf, die über einen Winkel von 180° hinausgehen. Beispielsweise können diese einen Bereich von 270° aufweisen, wobei sich entgegengesetzte Biegungen direkt aneinander anschließen und keinen oder zumindest nicht notwendigerweise einen geraden Abschnitt aufweisen. Dadurch kann die für den Wärmeübergang vom Heatpipekühlkörper 1 an das Kühlmedium 6 wirksame Oberfläche 4 des ersten Körperabschnitts 21 weiter erhöht werden. Dies verbessert die Leistungsfähigkeit des Heatpipekühlkörpers 1 weiter.

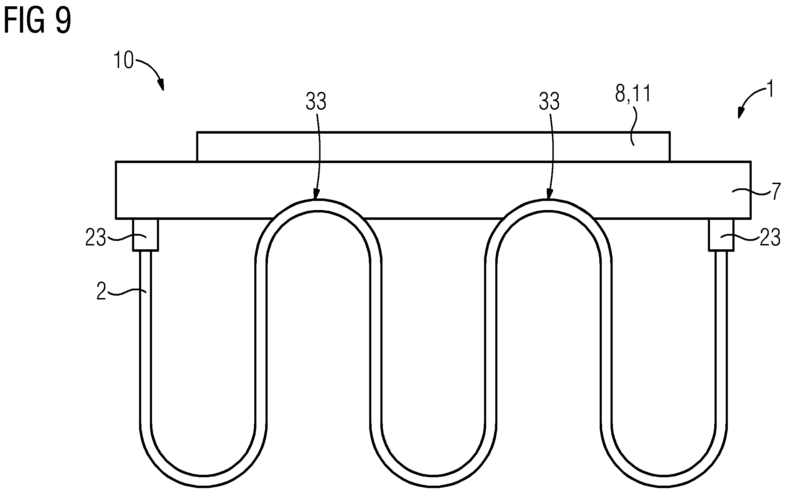

Die FIG 9 zeigt ein weiteres Ausführungsbeispiel eines Heatpipekühlkörpers 1 bzw. einer Leistungshalbleitereinheit 10. Zur Vermeidung von Wiederholungen wird auf die Beschreibung zu den Figuren 1 bis 8, sowie auf die dort eingeführten Bezugszeichen verwiesen. Die Bodenplatte 7 dieses Ausführungsbeispiels weist Ausnehmungen 33 auf. Diese Ausnehmungen 33 sind derart ausgebildet, um einen Teil des ersten Körperabschnitts 21 des Körpers 2 aufnehmen. Dabei hat es sich als vorteilhaft erwiesen. Die Ausnehmungen 33 mit einer gebogenen Grenzfläche gegenüber der Bodenplatte 7 auszuführen. Dadurch kann der Körper 2 an der Bodenplatte 7 anliegen. Durch die Ausnehmung 33 vergrößert sich der für den Wärmeübergang zwischen Bodenplatte 7 und Körper 2 wirksame Oberfläche. Diese Vergrößerung der wirksamen Oberfläche führt zu einer verbesserten Leistungsfähigkeit des Heatpipekühlkörpers 1.

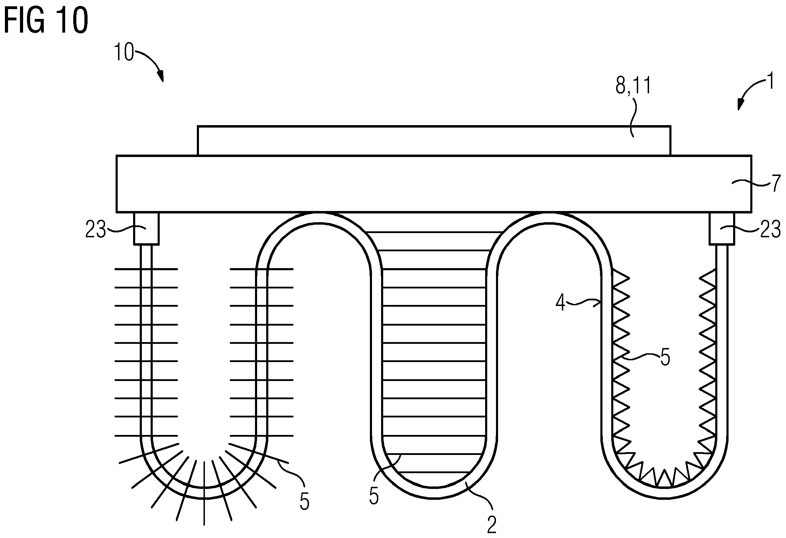

Die FIG 10 zeigt ein weiteres Ausführungsbeispiel eines Heatpipekühlkörpers 1 bzw. einer Leistungshalbleitereinheit 10. Zur Vermeidung von Wiederholungen wird auf die Beschreibung zu den Figuren 1 bis 9, sowie auf die dort eingeführten Bezugszeichen verwiesen. An dem Körper 2 im ersten Körperabschnitt 21 sind dabei Kühlrippen 5 angeordnet. Diese werden oftmals auch als Fins oder Pins bezeichnet. Sie können als Stäbe oder Platte an der Oberfläche 4 des ersten Körperabschnitts 21 angeordnet sein. Sie können alternativ oder ergänzend auch in einer dreieckförmigen, wie beispielsweise einer prismaförmigen Struktur an der Oberfläche 4 des ersten Körperabschnitts 21 angeordnet sein. Ebenso ist es möglich, wie in der Mitte dargestellt, die Kühlrippen zwischen zwei Bereichen des ersten Körperabschnitts 21 anzuordnen.

Als besonders vorteilhaft hat es sich herausgestellt, wenn die Kühlrippen 5 parallel zur Bodenplatte 7 oder parallel zum zweiten Körperabschnitt 21 verlaufen. Dann ist die Erwärmung in den Kühlrippen 5 besonders homogen und es entstehen keine mechanischen Spannungen aufgrund inhomogener Erwärmung von Teilen des Heatpipekühlkörpers 1.

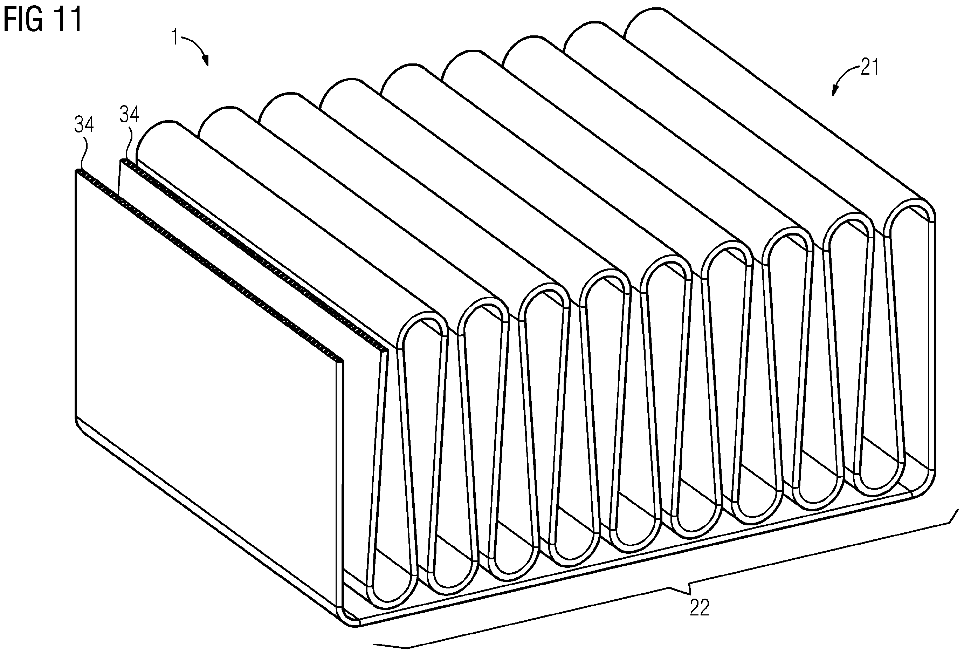

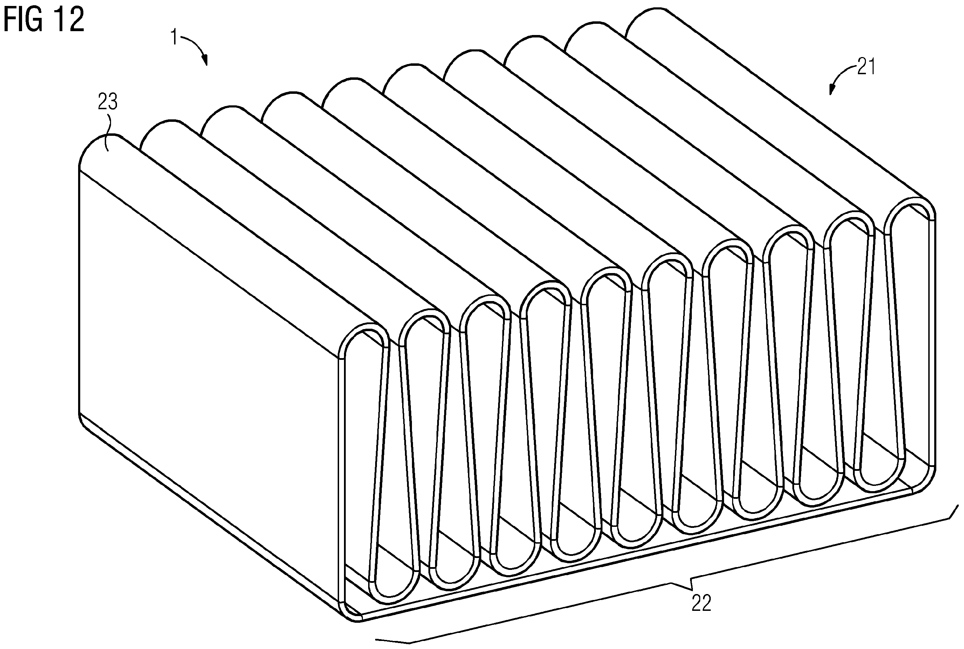

Die FIG 11 zeigt ein weiteres Ausführungsbeispiel eines Heatpipekühlkörpers 1, der ohne Bodenplatte 7 ausgeführt ist. Zur Vermeidung von Wiederholungen wird auf die Beschreibung zu den Figuren 1 bis 10, sowie auf die dort eingeführten Bezugszeichen verwiesen. An dem zweiten Körperabschnitt kann die Wärmequelle 8 angeordnet werden. Dabei weist der Heatpipekühlkörper zwei offene Enden 34 auf. Schließt man diese offenen Enden 34 mit Hilfe eines Abschlussteils 23, so erhält der Körper 2 eine geschlossene Form. Dies ist in FIG 12 dargestellt. Zur Vermeidung von Wiederholungen wird auf die Beschreibung zu den Figuren 1 bis 11, sowie auf die dort eingeführten Bezugszeichen verwiesen.

Die in der FIG 12 unten verdeckt dargestellte Fläche bietet sich aufgrund unmittelbarer Nähe zu mehreren Kanälen oder Kanalsegmenten für die Kontaktierung mit der Wärmequelle an.

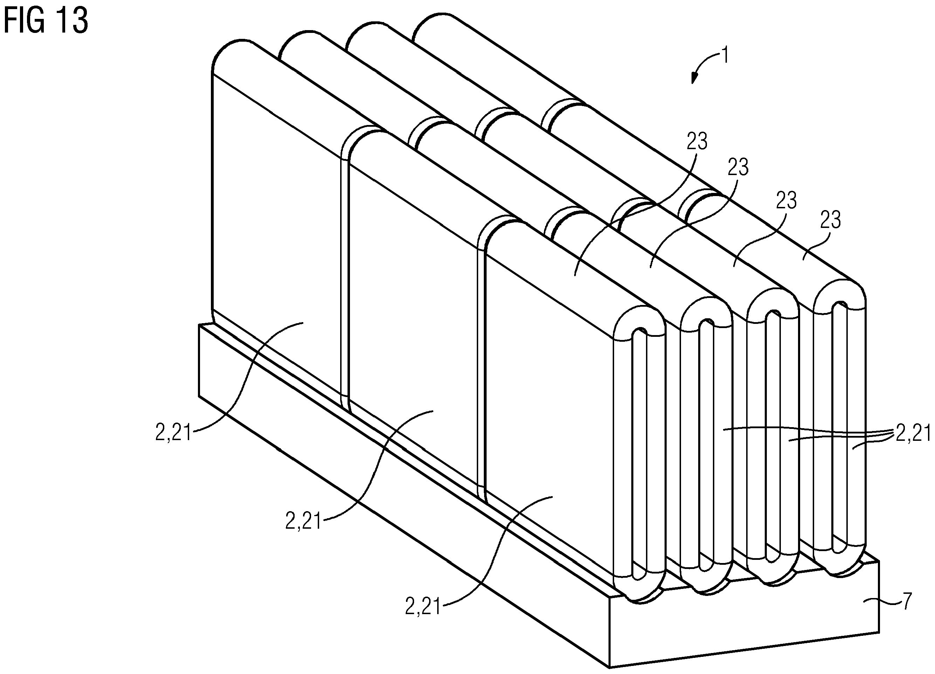

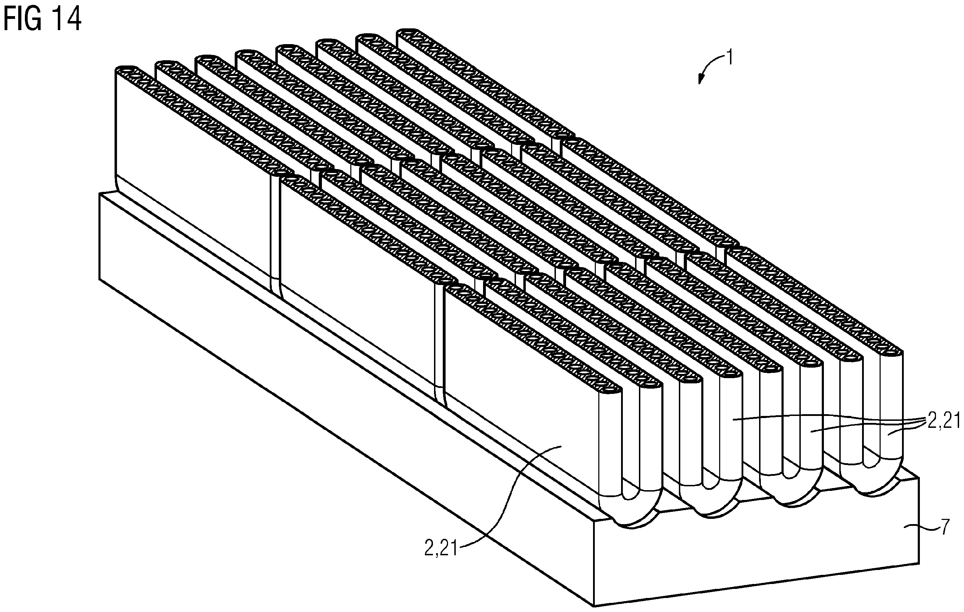

Die FIG 13 zeigt ein weiteres Ausführungsbeispiel eines Heatpipekühlkörpers 1. Zur Vermeidung von Wiederholungen wird auf die Beschreibung zu den Figuren 1 bis 12, sowie auf die dort eingeführten Bezugszeichen verwiesen. Dieser Heatpipekühlkörper 1 weist eine Vielzahl von Körpern 2 auf. Diese sind in diesem Ausführungsbeispiel U-förmig ausgestaltet. Durch ein Abschlussteil 23 ergibt sich eine Kreisform, die von dem Kühlmedium 6, insbesondere dem gasförmigen Kühlmedium 6, durchströmt werden kann. Die Körper sind mit der Bodenplatte 7 verbunden, die unter anderem eine Ausrichtung der Körper untereinander gewährleistet. Alternativ kann der erste Körperbereich auch mäanderförmig ausgestaltet sein. Damit ist auch die Verwendung einer Vielzahl von mäanderförmig ausgestalteten ersten Bereichen 21 des Körpers 2 bei der Verwendung einer Vielzahl von Körpern 2 für die Bildung eines Heatpipekühlkörpers 1 möglich. Eine Anordnung ohne Abschlussteile 23 zeigt FIG 14, aus der die U-förmige Ausgestaltung der Körper 2 ersichtlich ist.

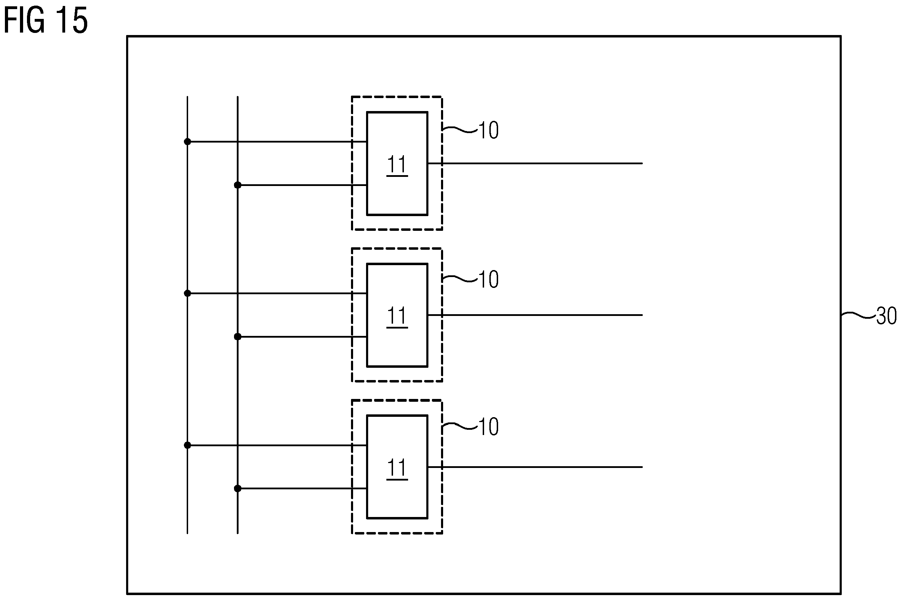

Die FIG 15 zeigt einen Stromrichter 30 mit drei Leistungshalbleitereinheiten 10. Die Leistungshalbleitereinheiten 10 weisen jeweils mindestens ein Leistungshalbleitermodul 11 auf. Das Leistungshalbleitermodul wird mittels eines hier nicht näher dargestellten Heatpipekühlkörpers 1 gekühlt bzw. entwärmt. Dabei kann der Heatpipekühlkörper 1 gemäß einer der zuvor erläuterten Figuren ausgebildet sein.

Zusammenfassend betrifft die Erfindung einen Heatpipekühlkörper, wobei der Heatpipekühlkörper für einen Betrieb als pulsierende Heatpipe eingerichtet ist, wobei der Heatpipekühlkörper einen Körper aufweist. Zur Verbesserung der Leistungsfähigkeit und Herstellbarkeit des Heatpipekühlkörpers wird vorgeschlagen, dass der Körper im Innern mindestens einen geschlossenen Kanal, insbesondere einen mäanderförmig ausgebildeten Kanal, aufweist, wobei der Körper einen ersten Körperabschnitt aufweist, der mäanderförmig oder U-förmig ausgebildet ist, wobei der erste Körperabschnitt von einem Kühlmedium, insbesondere einem gasförmigen Kühlmedium, entlang der Oberfläche des ersten Körperabschnitts durchströmbar ist. Ferner betrifft die Erfindung ein Verfahren zur Herstellung eines derartigen Heatpipekühlkörpers, wobei in einem ersten Schritt der Körper oder Blockteile in einer Blockform hergestellt werden, wobei der Kanal sich in einer Ebene erstreckt, wobei in einem zweiten Schritt der Körper oder die Blockteile derart umgeformt oder gebogen werden, dass sich der erste Körperabschnitt mit einer mäanderförmigen oder U-förmigen Struktur ergibt. Die Erfindung betrifft weiter eine Leistungshalbleitereinheit und einen Stromrichter mit einem derartigen Heatpipekühlkörper, wobei die entstehende Wärme mittels des Heatpipekühlkörpers an das Kühlmedium abführbar ist.

Mit anderen Worten betrifft die Erfindung zusammenfassend einen Heatpipekühlkörper, wobei der Heatpipekühlkörper für einen Betrieb als pulsierende Heatpipe eingerichtet ist, wobei der Heatpipekühlkörper einen Körper aufweist. Zur Verbesserung der Leistungsfähigkeit und Herstellbarkeit des Heatpipekühlkörpers wird vorgeschlagen, dass der Körper im Innern mindestens einen geschlossenen Kanal, insbesondere einen wechselseitig gekrümmten oder mäanderförmig ausgebildeten Kanal, aufweist, wobei der Körper einen ersten Körperabschnitt aufweist, der gekrümmte, wechselseitig gekrümmt, mäanderförmig oder U-förmig ausgebildeten ist, wobei der erste Körperabschnitt von einem Kühlmedium, insbesondere einem gasförmigen Kühlmedium, entlang der Oberfläche des ersten Körperabschnitts durchströmbar ist, wobei Abschnitte des Kanals und/ oder bei mehr als einem Kanal unterschiedliche Kanäle parallel zueinander angeordnet sind. Ferner betrifft die Erfindung ein Verfahren zur Herstellung eines derartigen Heatpipekühlkörpers, wobei in einem ersten Schritt der Körper oder Blockteile in einer Blockform hergestellt werden, wobei der Kanal sich in einer Ebene erstreckt, wobei in einem zweiten Schritt der Körper oder die Blockteile derart umgeformt oder gebogen werden, dass sich der erste Körperabschnitt mit einer wechselseitig gekrümmten, mäanderförmigen oder U-förmigen Struktur ergibt. Die Erfindung betrifft weiter eine Leistungshalbleitereinheit und einen Stromrichter mit einem derartigen Heatpipekühlkörper, wobei die entstehende Wärme mittels des Heatpipekühlkörpers an das Kühlmedium abführbar ist.

## Patentansprüche

1. Heatpipekühlkörper (1), wobei der Heatpipekühlkörper (1) für einen Betrieb als pulsierende Heatpipe eingerichtet ist, wobei der Heatpipekühlkörper (1) einen Körper (2) aufweist, wobei der Körper (2) im Innern mindestens einen geschlossenen Kanal (3), insbesondere einen wechselseitig gekrümmten oder mäanderförmig ausgebildeten Kanal (3), aufweist, wobei im Kanal (3) eine Flüssigkeit angeordnet ist, wobei Teile der Flüssigkeit gasförmig im Kanal (3) vorhanden sind, wobei die Begrenzungsfläche des Kanals (3) glatt ausgeführt ist, wobei der Körper (2) einen ersten Körperabschnitt (21) aufweist, der gekrümmt, wechselseitig gekrümmt, mäanderförmig oder U-förmig ausgebildet ist, wobei der erste Körperabschnitt (21) von einem Kühlmedium (6), insbesondere einem gasförmigen Kühlmedium (6), entlang der Oberfläche (4) des ersten Körperabschnitts (21) durchströmbar ist, wobei Abschnitte des Kanals (3) und/oder bei mehr als einem Kanal (3) unterschiedliche Kanäle (3) parallel zueinander angeordnet sind, **dadurch gekennzeichnet, dass** sich der Körper (2) aus zwei Blockteilen (24) zusammensetzt, wobei Teile des Kanals (3) jeweils an einer Grenzfläche der Blockteile (24) angeordnet sind.

2. Heatpipekühlkörper (1) nach Anspruch 1, wobei ein senkrecht zum Kanal (3) ausgerichtete Querschnitt des Körpers (2) im ersten Körperabschnitt (21) über eine ununterbrochene Länge von mindestens 80% der Gesamtlänge des Körpers (2) entlang des Kanals (3) die gleichen Abmessungen aufweist.

3. Heatpipekühlkörper (1) nach einem der Ansprüche 1 oder 2, wobei der Heatpipekühlkörper (1) am ersten Körperabschnitt (21) Kühlrippen (5) aufweist.

4. Heatpipekühlkörper (1) nach einem der Ansprüche 1 bis 3, wobei der Heatpipekühlkörper (1) mindestens zwei Körper (2) aufweist.

5. Heatpipekühlkörper (1) nach Anspruch 4, wobei die Körper (2) aus Sicht des durchströmenden Kühlmediums (6) hintereinander angeordnet sind.

6. Heatpipekühlkörper (1) nach einem der Ansprüche 1 bis 5, wobei der Heatpipekühlkörper (1) eine Bodenplatte (7) aufweist, wobei die Bodenplatte (7) mit dem Körper (2) wärmeleitend verbunden ist, wobei die Bodenplatte (7) für die Verbindung mit einer Wärmequelle (8) vorgesehen ist.

7. Heatpipekühlkörper (1) nach Anspruch 6, wobei die Wärmequelle (8) am Rand der Bodenplatte (7) angeordnet ist.

8. Heatpipekühlkörper (1) nach einem der Ansprüche 1 bis 7, wobei der erste Körperabschnitt (21) U-förmig ausgebildet ist, wobei der erste Körperabschnitt (21) mit einem Abschlussteil (23) derart, insbesondere mit sich selbst, verbunden ist, dass sich ein ringförmiger Körper ergibt.

9. Heatpipekühlkörper (1) nach einem der Ansprüche 1 bis 8, wobei der Körper (2) einen zweiten Körperabschnitt (22) aufweist, der eine ebene Oberfläche (9) aufweist, wobei die Oberfläche (9) für die Verbindung mit einer Wärmequelle (8) vorgesehen ist.

10. Heatpipekühlkörper (1) nach einem der Ansprüche 1 bis 9, wobei der Querschnitt des Kanals eine minimale Ausdehnung im Bereich von 0,5mm bis 5mm aufweist.

11. Heatpipekühlkörper (1) nach einem der Ansprüche 1 bis 10, wobei der erste Körperabschnitt (21) fügestellenfrei ausgebildet ist.

12. Heatpipekühlkörper (1) nach einem der Ansprüche 1 bis 11, wobei der Körper (2) monolithisch ausgebildet ist.

13. Leistungshalbleitereinheit (10) aufweisend
- einen Heatpipekühlkörper (1) nach einem der Ansprüche 1 bis 12 und
- mindestens ein Leistungshalbleitermodul (11),
wobei das Leistungshalbleitermodul (11) thermisch leitend mit dem Heatpipekühlkörper (1) derart verbunden ist, dass die durch Verlustleistung des Leistungshalbleitermoduls (11) entstehende Wärme mittels des Heatpipekühlkörpers (1) an das Kühlmedium (6), insbesondere an das gasförmige Kühlmedium (6) oder an die Umgebungsluft, abführbar ist.

14. Stromrichter (30) mit einem Heatpipekühlkörper (1) nach einem der Ansprüche 1 bis 12 oder einer Leistungshalbleitereinheit (10) nach Anspruch 13.

15. Verfahren zur Herstellung eines Heatpipekühlkörpers (1) nach einem der Ansprüche 1 bis 13, wobei in einem ersten Schritt Blockteile (24) in Blockform hergestellt werden, wobei die Blockteile (24) derart zu dem Körper (2) verbunden werden, dass im Innern der verbundenen Blockteile (24) ein Kanal (3) entsteht, wobei der Kanal (3) sich in einer Ebene erstreckt, wobei in einem zweiten Schritt der Körper (2) oder die Blockteile (24) derart umgeformt oder gebogen werden, dass sich der erste Körperabschnitt (21) mit einer gekrümmten, wechselseitig gekrümmten, insbesondere einer quer zur Verlaufsrichtung oder einer Vorzugsrichtung der Verlaufsrichtung des Kanals (3) gekrümmten, mäanderförmigen oder U-förmigen Struktur ergibt.

16. Verfahren nach Anspruch 15, wobei der Körper (2) über mindestens 80% der Abmessung in einer ersten Richtung über die Länge in erster Richtung ununterbrochen fügestellenfrei ausgebildet ist, wobei die erste Richtung der Vorzugsrichtung des Verlaufs des Kanals (3) entspricht.

17. Verfahren nach einem der Ansprüche 15 bis 16, wobei der Körper (2) oder die Blockteile (24) in einer Blockform mittels eines Extrusionsverfahrens, insbesondere eines Strangpressverfahrens oder eines Stranggussverfahrens, oder eines Spritzgussverfahrens hergestellt wird.

18. Verfahren nach einem der Ansprüche 15 bis 17, wobei der Körper (2) gefräst, gedrückt oder gepresst wird, insbesondere der Kanal (3) in die zwei Blockteile (24) gefräst, gedrückt oder gepresst wird.

## Claims

1. Heat pipe heat sink (1), wherein the heat pipe heat sink (1) is configured for operation as a pulsating heat pipe, wherein the heat pipe heat sink (1) comprises a body (2), wherein internally the body (2) comprises at least one closed channel (3), more particularly a channel (3) embodied as alternatingly curved or serpentine, wherein a fluid is arranged in the channel (3), wherein parts of the fluid are present in the channel (3) in gaseous form, wherein the periphery of the channel (3) is designed to be smooth, wherein the body (2) has a first body portion (21) which is embodied as curved, alternatingly curved, serpentine or U-shaped, wherein a coolant (6), more particularly a gaseous coolant (6), can flow through the first body portion (21) along the surface (4) of the first body portion (21), wherein portions of the channel (3) and/or, if there is more than one channel (3), different channels (3) are arranged parallel to one another, **characterised in that** the body (2) is composed of two block parts (24), wherein parts of the channel (3) are arranged on a boundary area of the block parts (24) in each case.

2. Heat pipe heat sink (1) according to claim 1, wherein a cross-section of the body (2) oriented at right angles to the channel (3) in the first body portion (21) has the same dimensions over an uninterrupted length of at least 80% of the overall length of the body (2) along the channel (3).

3. Heat pipe heat sink (1) according to one of claims 1 or 2, wherein the heat pipe heat sink (1) has cooling fins (5) on the first body portion (21).

4. Heat pipe heat sink (1) according to one of claims 1 to 3, wherein the heat pipe heat sink (1) has at least two bodies (2) .

5. Heat pipe heat sink (1) according to claim 4, wherein the bodies (2) are arranged in series when seen from the perspective of the coolant (6) flowing therethrough.

6. Heat pipe heat sink (1) according to one of claims 1 to 5, wherein the heat pipe heat sink (1) has a baseplate (7), wherein the baseplate (7) is connected to the body (2) in a thermally conductive manner, wherein the baseplate (7) is provided for connecting to a heat source (8).

7. Heat pipe heat sink (1) according to claim 6, wherein the heat source (8) is arranged at the edge of the baseplate (7).

8. Heat pipe heat sink (1) according to one of claims 1 to 7, wherein the first body portion (21) is embodied as U-shaped, wherein the first body portion (21) is connected to a terminating part (23), in particular to itself, in such a way that a ring-shaped body is produced.

9. Heat pipe heat sink (1) according to one of claims 1 to 8, wherein the body (2) has a second body portion (22) which has a level surface (9), wherein the surface (9) is provided for connecting to a heat source (8).

10. Heat pipe heat sink (1) according to one of claims 1 to 9, wherein the cross-section of the channel has a minimum dimension in the range of 0.5mm to 5mm.

11. Heat pipe heat sink (1) according to one of claims 1 to 10, wherein the first body portion (21) is embodied without joints.

12. Heat pipe heat sink (1) according to one of claims 1 to 11, wherein the body (2) is embodied monolithically.

13. Power semiconductor unit (10) having
- a heat pipe heat sink (1) according to one of claims 1 to 12 and
- at least one power semiconductor module (11),
wherein the power semiconductor module (11) is connected to the heat pipe heat sink (1) in a thermally conductive manner in such way that the heat generated due to power loss of the power semiconductor module (11) can be dissipated by means of the heat pipe heat sink (1) to the coolant (6), more particularly to the gaseous coolant (6), or to the ambient air.

14. Power converter (30) comprising a heat pipe heat sink (1) according to one of claims 1 to 12 or a power semiconductor unit (10) according to claim 13.

15. Method for producing a heat pipe heat sink (1) according to one of claims 1 to 13, wherein in a first step block parts (24) are produced in block mould, wherein the block parts (24) are connected in such a way to the body (2) that a channel (3) is produced in the interior of the connected block parts (24), wherein the channel (3) extends in a plane, wherein in a second step the body (2) or the block parts (24) are formed or bent in such a way that the first body portion (21) is produced with a structure that is curved, alternatingly curved, more particularly curved transversely with respect to the flow direction or a preferred direction of the flow direction of the channel (3), serpentine or U-shaped.

16. Method according to claim 15, wherein the body (2) is embodied as uninterruptedly free of joints over the length in the first direction over at least 80% of the dimension in a first direction, wherein the first direction corresponds to the preferred direction of the course of the channel (3).

17. Method according to one of claims 15 to 16, wherein the body (2) or the block parts (24) is or are produced in a block mould by means of an extrusion method, more particularly an extrusion press method or a continuous casting method, or an injection moulding method.

18. Method according to one of claims 15 to 17, wherein the body (2) is milled, forced or pressed, more particularly the channel (3) is milled, forced or pressed into the two block parts (24).

## Revendications

1. Puits (1) de chaleur à caloduc, dans lequel le puits (1) de chaleur à caloduc est agencé pour un fonctionnement comme caloduc pulsé, dans lequel le puits (1) de chaleur à caloduc comporte un corps (2), dans lequel le corps (2) a à l'intérieur au moins un conduit (3) fermé, en particulier un conduit (3) incurvé réciproquement ou sinueux, dans lequel un liquide est disposé dans le conduit (3), dans lequel il y a des parties du liquide sous forme gazeuse dans le conduit (3), dans lequel la surface de démarcation du conduit (3) est réalisée lisse, dans lequel le corps (2) a une première partie (21) de corps qui est incurvée, incurvée réciproquement, sinueuse ou en forme de U, dans lequel un fluide (6) de refroidissement, en particulier un fluide (6) de refroidissement gazeux, peut passer dans la première partie (21) du corps le long de la surface (4) de la première partie (21) du corps, dans lequel des tronçons du conduit (3) et/ou des conduits (3) différents, lorsqu'il y a plus qu'un seul conduit (3), sont disposés parallèlement entre eux, **caractérisé en ce que**
le corps (2) est composé de deux parties (24) en bloc, dans lequel des parties du conduit (3) sont disposées respectivement sur une surface limite des parties (24) en bloc.

2. Puits (1) de chaleur à caloduc suivant la revendication 1, dans lequel une section transversale, dirigée perpendiculairement au conduit (3), du corps (2) a dans la première partie (21) du corps les mêmes dimensions sur une longueur ininterrompue d'au moins 80% de la longueur totale du corps (2) le long du conduit (3).

3. Puits (1) de chaleur à caloduc suivant l'une des revendications 1 ou 2, dans lequel le puits (1) de chaleur à caloduc a des ailettes (5) de refroidissement sur la première partie (21) du corps.

4. Puits (1) de chaleur à caloduc suivant l'une des revendications 1 à 3, dans lequel le puits (1) de chaleur à caloduc a au moins deux corps (2).

5. Puits (1) de chaleur à caloduc suivant la revendication 4, dans lequel les corps (2) sont disposés, du point de vue du fluide (6) de refroidissement qui s'écoule, les uns derrière les autres.

6. Puits (1) de chaleur à caloduc suivant l'une des revendications 1 à 5, dans lequel le puits (1) de chaleur à caloduc a une plaque (7) de fond, dans lequel la plaque (7) de fond est reliée d'une manière conductrice de la chaleur au corps (2), dans lequel la plaque (7) de fond est prévue pour la liaison avec une source (8) de chaleur.

7. Puits (1) de chaleur à caloduc suivant la revendication 6, dans lequel la source (8) de chaleur est disposée au bord de la plaque (7) de fond.

8. Puits (1) de chaleur à caloduc suivant l'une des revendications 1 à 7, dans lequel la première partie (21) du corps est en forme de U, dans lequel la première partie (21) du corps est reliée à une partie (23) de fermeture, en particulier à soi-même, de manière à donner un corps de forme annulaire.

9. Puits (1) de chaleur à caloduc suivant l'une des revendications 1 à 8, dans lequel le corps (2) a une deuxième partie (22) de corps, qui a une surface (9) plane, dans lequel la surface (9) est prévue pour la liaison à une source (8) de chaleur.

10. Puits (1) de chaleur à caloduc suivant l'une des revendications 1 à 9, dans lequel la section transversale du conduit a une étendue minimum dans la plage de 0,5 mm à 5 mm.

11. Puits (1) de chaleur à caloduc suivant l'une des revendications 1 à 10, dans lequel la première partie (21) du corps est constituée sans point de jonction.

12. Puits (1) de chaleur à caloduc suivant l'une des revendications 1 à 11, dans lequel le corps (2) est de constitution monolithique.

13. Unité (10) à semiconducteur de puissance, comportant
- un puits (1) de chaleur à caloduc suivant l'une des revendications 1 à 12, et
- au moins un module (11) à semiconducteur de puissance,
dans lequel le module (11) à semiconducteur de puissance est relié d'une manière conductrice thermiquement au puits (1) de chaleur à caloduc, de manière à ce que la chaleur créée par de la puissance perdue du module (11) à semiconducteur de puissance puisse, au moyen du puits (1) de chaleur à caloduc, être dissipée au fluide (6) de refroidissement, en particulier au fluide (6) de refroidissement gazeux ou à l'air ambiant.

14. Convertisseur (30) comprenant un puits (1) de chaleur à caloduc suivant l'une des revendications 1 à 12 ou une unité (10) à semiconducteur de puissance suivant la revendication 13.

15. Procédé de fabrication d'un puits (1) de chaleur à caloduc suivant l'une des revendications 1 à 13, dans lequel on produit dans un premier stade des parties (24) en bloc sous forme de bloc, dans lequel on relie les parties (24) en bloc au corps (2), de manière à créer à l'intérieur des parties (24) en bloc reliées, un conduit (3), dans lequel le conduit (3) s'étend dans un plan, dans lequel dans un deuxième stade on déforme ou on courbe le corps (2) ou les parties (24) en bloc, de manière à ce que la première partie (21) du corps donne une structure sinueuse, en forme de U ou incurvée, incurvée réciproquement, en particulier incurvée transversalement à la direction d'étendue ou à une direction préférentielle de la direction d'étendue du conduit (3).

16. Procédé suivant la revendication 15, dans lequel le corps (2) est, sur au moins 80% de la dimension dans une première direction, constitué sans point de jonction en étant ininterrompu sur la longueur dans la première direction, la première direction correspondant à la direction préférée de l'étendue du conduit (3).

17. Procédé suivant l'une des revendications 15 à 16, dans lequel on fabrique le corps (2) ou les parties (24) en bloc au moyen d'un procédé d'extrusion, en particulier d'un procédé de filage à la presse ou d'un procédé de coulée continue ou d'un procédé de moulage par injection.

18. Procédé suivant l'une des revendications 15 à 17, dans lequel on fraise, imprime ou emboutit le corps (2) en particulier on fraise, imprime ou emboutit le conduit (3) dans les deux parties (24) en bloc.
